# FASCICULE DE BREVET EUROPEEN

(11) **EP 1 670 053 B1**
(45) Date de publication et mention de la délivrance du brevet: **26.03.2008**
(21) Numéro de dépôt: 05354040.7
(22) Date de dépôt: 28.11.2005
(51) Int. Cl.: H01L 21/762

(54) **Procédé d'isolation de motifs formés dans un film mince en matériau semiconducteur oxydable**
Verfahren zur Isolation von Teilbereichen in einem dünnen Film eines oxidierbaren Halbleitermaterials
Isolation process of parts of a thin film in an oxydizable semiconductor material

(30) Priorité: 08.12.2004 FR 0413061
(43) Date de publication de la demande: 14.06.2006
(73) Titulaire: COMMISSARIAT A L'ENERGIE ATOMIQUE, 75752 Paris (FR)
(72) Inventeur: Barbe, Jean-Charles, 38100 Grenoble (FR); Vinet, Maud, F-38140 Rives (FR); Previtali, Bernard, 38100 Grenoble (FR); Poiroux, Thierry, 38340 Voreppe (FR)
(74) Mandataire: Jouvray, Marie-Andrée

(56) Documents cités:
- US-A- 5 308 445
- US-A- 5 393 692
- US-A- 5 629 230
- US-A- 6 093 622
- US-A1- 2002 060 355

## Description

### Domaine technique de l'invention

L'invention concerne un procédé d'isolation de motifs formés dans un film mince en un premier matériau semi-conducteur oxydable, d'une épaisseur prédéterminée inférieure ou égale à 20nm et disposé sur un support, comportant successivement :
- la formation, sur le film mince, d'un masque définissant, dans le film mince, des zones libres et des zones recouvertes par le masque destinées à former sensiblement les motifs,
- l'oxydation des zones libres du film mince,
- le retrait du masque de manière à libérer le film mince structuré sous forme de motifs isolés par des zones oxydées.

### État de la technique

Dans de nombreux domaines de la microélectronique, les dispositifs issus des technologies conventionnelles sur silicium massif sont, de plus en plus, remplacés par des dispositifs sur substrat Silicium sur Isolant (SOI) ou sur substrat SOI sous contrainte, plus connu sous le nom anglo-saxon "strained SOI". Un substrat SOI est constitué d'un substrat en silicium sur lequel est disposé une couche isolante, par exemple en oxyde, recouverte d'un film mince en silicium et un substrat "strained SOI" est un substrat SOI sur lequel est disposé un film mince en silicium contraint ou déformé. De tels substrats SOI permettent une isolation électrique par rapport au substrat des micro-composants destinés à être intégrés, tels que les transistors MOS, grâce à la présence de la couche enterrée d'isolant disposée sur le substrat en silicium. Ils assurent également une réduction des capacités parasites et des effets de canaux courts.

L'isolation électrique des micro-composants ou des motifs en silicium est, généralement complétée par une oxydation thermique locale de silicium. L'isolation par oxydation locale de silicium, également connue sous le nom d'isolation LOCOS, est réalisée au moyen d'un masque structuré constitué d'au moins deux couches superposées en oxyde et en nitrure disposé sur le film mince en silicium. L'isolation LOCOS permet alors de former, dans le film mince, des zones en silicium formant des motifs séparés, et donc isolés électriquement, les uns des autres par des zones oxydées.

Cependant, lorsque les motifs, formés dans un film mince et éventuellement isolés par LOCOS, ont une épaisseur inférieure ou égale à 20nm, un phénomène de démouillage en phase solide des motifs a tendance à se produire à haute température, lors de la fabrication des micro-composants. Ce phénomène est, généralement, observé lors des étapes de recuit, qui sont réalisées à partir de 850°C et par exemple à 950°C.

En effet, les motifs formés dans le film mince en silicium sont intrinsèquement instables et ils évoluent spontanément vers une forme d'équilibre atteinte par transport de matière, majoritairement par diffusion de surface et qui, dans des cas extrêmes, correspond à une population de cristaux disjoints les uns des autres. L'énergie du système formé par cette population de cristaux est, alors, plus faible que celle du motif initial. Cette forme d'équilibre est donc néfaste pour la suite des étapes de fabrication d'un micro-composant, notamment d'un transistor MOS où les différentes zones du transistor à définir dans le motif mince, par exemple la source, le drain, le canal..., peuvent ne plus être connexes. Un tel phénomène de démouillage se retrouve également pour tout type de film mince structuré, en matériau semi-conducteur capable de former un oxyde stable lors d'une oxydation thermique, tel que, par exemple, un composé de silicium et de germanium (SiGe).

Ce phénomène étant induit par la température élevée des étapes de fabrication des micro-composants et notamment les étapes de recuit, certains ont tenté de réaliser le recuit à une température moins élevée. En effet, pour des épaisseurs de films minces de l'ordre de 5 nm et pour des durées et des atmosphères de recuits usuelles, le fait de réaliser le recuit à une température inférieure à 800°C rend les films minces peu sensibles au démouillage. Cependant, les étapes suivantes, par exemple l'étape de nettoyage qui nécessite une désorption d'espèces ou bien l'étape d'épitaxie, ne permettent pas d'utiliser une telle température de recuit puisque, pour obtenir une interface capable d'assurer une bonne qualité cristalline du matériau épitaxié, la température de recuit ne peut pas être inférieure à 800°C.

### Objet de l'invention

L'invention a pour but un procédé d'isolation de motifs formés dans un film mince en matériau semi-conducteur oxydable et d'une épaisseur inférieure ou égale à 20nm, et de préférence inférieure ou égale à 10 nm, permettant de remédier aux inconvénients de l'art antérieur.

Plus particulièrement, le procédé d'isolation des motifs permet non seulement d'isoler électriquement les motifs les uns des autres mais également de les rendre stables aux températures élevées utilisées lors de certaines étapes de fabrication de micro-composants.

Ce but est atteint par les revendications annexées.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :

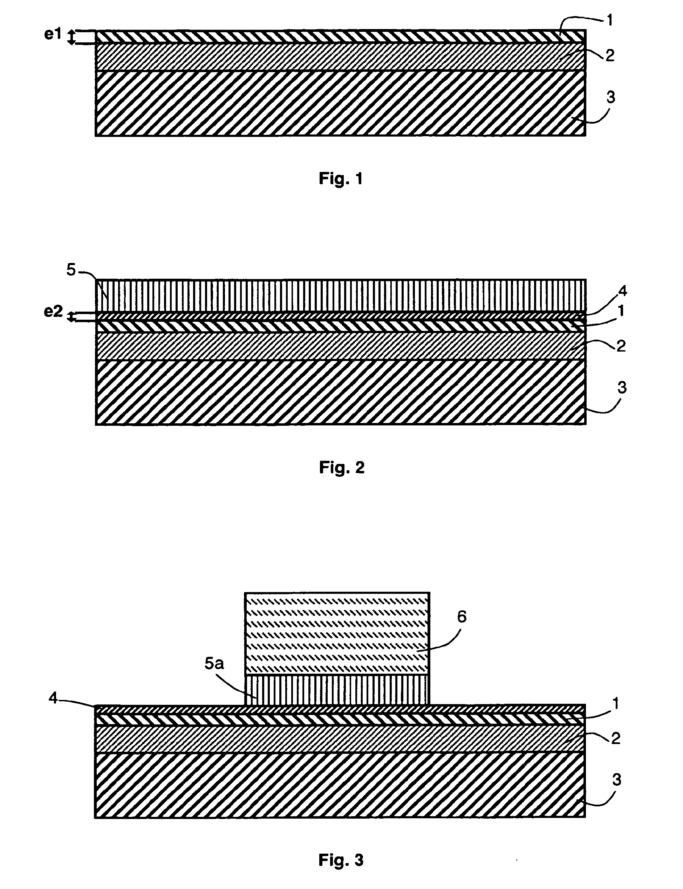

Les figures 1 à 8 représentent schématiquement, en coupe, différentes étapes d'un mode particulier d'isolation de motifs formés dans un film mince, selon l'invention.

### Description de modes particuliers de réalisation

Selon un mode particulier de réalisation représenté aux figures 1 à 8, des motifs 1 a sont formés dans un film mince 1 disposé sur un support 3 et sont séparés les uns des autres par des zones 1b oxydées. Les zones oxydées 1b permettent non seulement d'isoler électriquement les motifs 1 a les uns des autres mais également de les ancrer de manière à empêcher le phénomène de démouillage susceptible de se produire lors de certaines étapes de fabrication de micro-composants, réalisées à des températures élevées.

Le film mince 1 est en matériau semi-conducteur oxydable, de préférence, choisi parmi le silicium et un composé de silicium et de germanium et il a une épaisseur prédéterminée e1 inférieure ou égale à 20nm et, de préférence, inférieure ou égale à 10nm.

Ainsi, comme représenté à la figure 1, le film mince 1 est préalablement disposé sur la face supérieure d'une couche intermédiaire 2 recouvrant un support 3. Plus particulièrement, le matériau formant le support 3 est différent du matériau semi-conducteur oxydable du film mince 1. Dans l'exemple décrit, le support 3 est un substrat en silicium et la couche intermédiaire 2 est une couche isolante électriquement, l'ensemble formant alors un substrat SOI. La couche isolante électriquement peut être constituée par un composé choisi parmi la silice amorphe, l'alumine, le nitrure de silicium, le quartz et l'oxyde d'hafnium (HfO₂). La couche intermédiaire 2 peut également être une couche semi-conductrice, constituée, par exemple, par un composé de silicium et de germanium.

A la figure 2, deux couches, respectivement en oxyde 4 et en nitrure 5, sont successivement, formées sur la totalité de la surface libre du film mince 1. La couche en oxyde 4, par exemple en oxyde de silicium, a, de préférence, une épaisseur e2 comprise entre 2 nm et 5 nm. Elle peut être formée par dépôt chimique en phase vapeur à basse pression, également appelé procédé LPCVD, par dépôt chimique en phase vapeur assisté par plasma, également appelé procédé PECVD ou bien par oxydation thermique d'une fine épaisseur du film mince 1. La couche en oxyde 4 peut, également, être constituée par un empilement SiO₂/HfO₂, la couche en SiO₂ pouvant être soit déposée, soit formée naturellement sur le film mince, lors du dépôt de la couche en HfO₂.

Puis, une couche en nitrure 5, par exemple en nitrure de silicium, est déposée sur la totalité de la surface libre de la couche en oxyde 4. La couche en nitrure 5 a, de préférence, une épaisseur comprise entre 10 nm et 70 nm et elle est, par exemple, déposée par dépôt LPCVD.

Les couches en nitrure 5 et en oxyde 4 sont, ensuite, structurées, de manière sélective. Ainsi, la structuration s'arrête à la surface du film mince 1. La structuration est, par exemple, réalisée par photolithographie ou par une méthode appelée "lithographie e-beam" qui consiste à réaliser une lithographie par l'intermédiaire d'un masqueur électronique puis par gravures successives des couches en nitrure 5 et en oxyde 4.

A la figure 3, la couche en nitrure 5 est structurée par photolithographie, au moyen d'une résine photosensible 6 structurée. Une couche en résine photosensible est, par exemple, disposée à la surface libre de la couche en nitrure et elle est structurée sous forme de motifs. La résine photosensible structurée 6 comporte alors des motifs délimités par des zones ouvertes laissant apparaître la surface libre de la couche en nitrure. La couche en nitrure 5 est ensuite gravée, dans les zones ouvertes de la résine photosensible 6 structurée, de sorte que les zones de la couche en nitrure 5 non recouvertes par les motifs de la résine 6 soient éliminées. La gravure de la couche en nitrure 5 est sélective dans la mesure où seule la couche en nitrure 5 est gravée, la gravure s'arrêtant à la surface de la couche en oxyde 4.

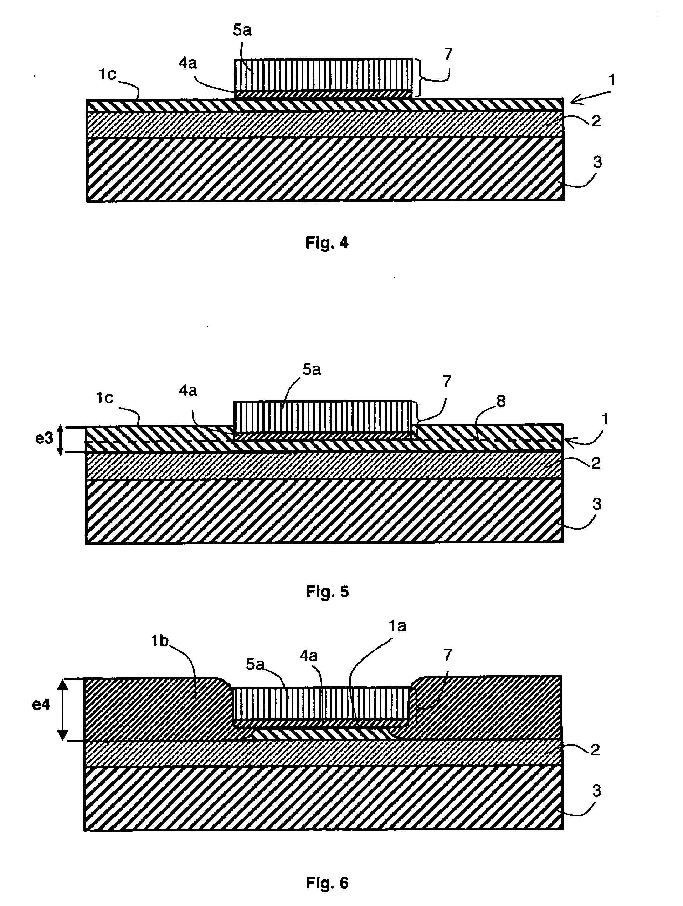

Comme représenté à la figure 4, la résine photosensible structurée 6 est, ensuite, retirée avant que la couche en oxyde 4 ne soit gravée de manière sélective, à travers la couche en nitrure 5, préalablement structurée. La gravure de la couche en oxyde 4 est sélective dans la mesure où seule la couche en oxyde 4 est gravée, la gravure s'arrêtant à la surface du film mince 1. Les zones de la couche en oxyde 4 non recouvertes par les motifs de la couche en nitrure 5 sont alors éliminées.

Ainsi, à la suite de cette étape de structuration, seules les zones préalablement recouvertes 5a et 4a, respectivement de la couche en nitrure 5 et de la couche en oxyde 4, restent sur la surface du film mince 1 et forment un masque 7. Le masque 7 permet ainsi de définir, dans le film mince 1, deux types de zones : des zones recouvertes par ledit masque 7 et destinées à former sensiblement les motifs 1 a du film mince 1 et des zones libres 1 c formées par le reste du film mince 1.

Puis, comme illustré à la figure 5, une étape de croissance par épitaxie sélective est réalisée de manière à accroître l'épaisseur des zones libres 1 c tandis que les zones recouvertes par le masque 7 conservent une épaisseur constante correspondant à l'épaisseur e1 du film mince 1. A la fin de l'étape de croissance, les zones libres 1 c ont une épaisseur totale e3 supérieure à l'épaisseur initiale e1 du film mince 1. L'épitaxie est sélective dans la mesure où seules les zones libres 1 c du film mince subissent la croissance par épitaxie, le reste du film mince 1 étant, en effet, protégé par le masque 7 le recouvrant. Ainsi, à la figure 5, la ligne 8 en traits pointillés illustre la position du film mince, avant l'étape de croissance, la différence de niveau entre la surface libre des zones libres 1c après l'étape de croissance et la ligne 8 correspondant, alors, aux zones libres épitaxiées durant l'étape de croissance.

Une étape d'oxydation des zones libres 1c du film mince est, ensuite, réalisée, de préférence, à haute température telle que, par exemple, 1050°C. L'étape d'oxydation permet non seulement d'oxyder totalement les zones libres 1 c mais également de définir les motifs 1 a. En effet, elle est réalisée à travers le masque 7, qui protège les zones qu'il recouvre de l'oxydation. Par oxydation totale des zones libres 1 c, on entend que les zones libres 1 c sont oxydées sur toute leur épaisseur e3. De plus, l'oxydation engendre une augmentation de l'épaisseur des zones oxydées 1b par rapport aux zones libres non oxydées. Ainsi, pour des zones oxydées en oxyde de silicium et des zones libres non oxydées en silicium, cette augmentation correspond à une augmentation d'un facteur de 1/0,45, c'est-à-dire de l'ordre de 2,22. Ainsi, l'épaisseur des zones libres 1 c étant e3, à la fin de l'étape d'oxydation, les zones oxydées 1b ont une épaisseur e4 correspondant sensiblement à 2,22 fois l'épaisseur e3.

Comme représentées à la figure 6, les zones oxydées 1 b se prolongent sous le masque 7 et l'interface entre les zones oxydées 1 b et les motifs 1 a est incurvée. Ainsi, bien que les zones libres 1 b soient totalement oxydées, les bordures des zones couvertes par le masque 7 ont été partiellement oxydées, de manière à former un bec d'oiseau dans les motifs 1 a en silicium. Les motifs 1 a sont alors séparés les uns des autres, et donc isolés électriquement, par les zones oxydées 1 b.

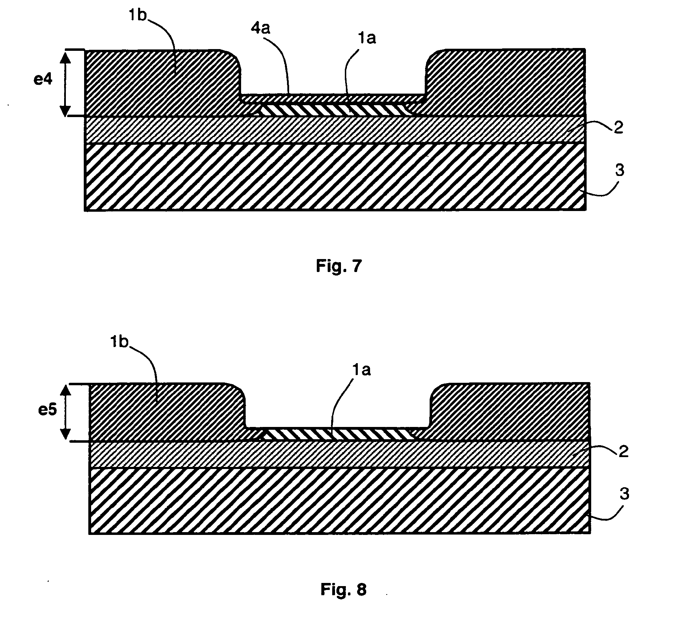

Puis, comme illustré aux figures 7 et 8, les couches en nitrure 5 et en oxyde 4 sont successivement retirées de manière à libérer les motifs 1 a. La couche en nitrure 5 est, par exemple, retirée par traitement chimique avec, par exemple, H₃PO₄. Une couche 4 en oxyde de silicium est, par exemple, retirée au moyen d'une solution d'acide fluorhydrique.

Lorsque la méthode de retrait de la couche en oxyde 4 n'est pas sélective, un tel retrait peut induire une consommation partielle des zones oxydées 1b, selon une épaisseur dépendant de la vitesse de consommation de l'oxyde de la couche 4 et de l'oxyde des zones oxydées 1 b. Ainsi, si les oxydes, respectivement des zones libres 1 b et de la couche 4 sont identiques, l'épaisseur consommée des zones libres, lors du retrait de la couche en oxyde 4 correspond à l'épaisseur e2 de la couche en oxyde 4. Dans ce cas, l'épaisseur e5 des zones oxydées 1 b, à l'issue du procédé d'isolation, correspond à l'épaisseur e4 des zones oxydées avant le retrait de la couche en oxyde 4 moins l'épaisseur e2 de la couche en oxyde 4.

Un tel procédé d'isolation permet donc de former et d'isoler électriquement des motifs dans un film mince en matériau semi-conducteur oxydable et d'une épaisseur inférieure ou égale à 20nm et, de préférence, inférieure ou égale à 10nm. Mais, contrairement à une isolation LOCOS selon l'art antérieur, il permet également de les rendre stables aux températures élevées, notamment lors des différentes étapes de fabrication d'un micro-composant.

En effet, un tel procédé d'isolation permet à chaque motif d'être entouré, à sa périphérie, d'une zone oxydée, notamment lors des différentes étapes de fabrication d'un micro-composant. Ceci permet d'obtenir une stabilité thermique car les zones oxydées entourant les motifs retardent le phénomène de démouillage des motifs. De plus, lorsque la couche intermédiaire 2 est une couche isolante, l'interface entre un motif 1 a, les zones oxydées 1 b l'entourant et la couche isolante 2 constitue un point d'ancrage, car elle correspond à une rugosité macroscopique, qui doit être contournée pour que le motif puisse subir le phénomène de démouillage.

Or, un procédé d'isolation LOCOS selon l'art antérieur ne permet pas d'obtenir des motifs stables à haute température, pendant les différentes étapes de fabrication d'un micro-composant. En effet, dans un procédé d'isolation LOCOS, l'épaisseur des zones oxydées dépend de l'épaisseur e1 du film mince et éventuellement de l'épaisseur e2 de la couche en oxyde du masque. Ainsi, pour un film mince ayant une épaisseur e1 inférieure ou égale à 20nm et, plus particulièrement inférieure ou égale à 10nm, l'épaisseur des zones oxydées à la fin d'un procédé d'isolation LOCOS selon l'art antérieur est insuffisante pour être conservée lors des différentes étapes de fabrication d'un micro-composant. A titre d'exemple, pour un film mince d'une épaisseur e1 de 8nm, les zones oxydées dans un procédé d'isolation LOCOS selon l'art antérieur ont une épaisseur e4 de 17 nm, avant l'étape de retrait de la couche en oxyde 4. Or, lors des différentes étapes de nettoyage associées au procédé de fabrication d'un transistor MOS, cette épaisseur e4 est entièrement consommée par gravure, libérant ainsi les flancs des motifs en silicium. Le phénomène de démouillage s'observant, généralement, lors de toute étape à haute température durant laquelle la surface supérieure du motif ainsi que ses parois latérales sont libres, l'isolation LOCOS selon l'art antérieur ne permet pas de remédier à ce phénomène pendant les différentes étapes de fabrication d'un micro-composant et notamment pendant des étapes de recuit.

Le fait de réaliser une étape de croissance par épitaxie sélective, entre l'étape de formation du masque et l'étape d'oxydation des zones libres du film mince, permet, au contraire, d'obtenir, à la fin du procédé d'isolation, des zones oxydées ayant une épaisseur suffisante pour être conservées lors des différentes étapes de fabrication d'un micro-composant. L'épaisseur supplémentaire obtenue par l'étape de croissance par épitaxie sélective, c'est-à-dire la formation de zones libres épitaxiées, permet, en effet, d'augmenter l'épaisseur totale des zones oxydées, à la fin du procédé d'isolation. Ainsi, l'épaisseur des zones épitaxiées est, de préférence, déterminée de manière à conserver des zones oxydées sur les flancs des motifs durant tout le procédé de fabrication de micro-composants. Les paramètres de l'étape de croissance par épitaxie sélective, et plus particulièrement l'épaisseur des zones épitaxiées est choisie de manière à ce que l'épaisseur finale e5 des zones oxydées soit supérieure ou égale à 17nm.

A titre d'exemple, pour un film mince en silicium d'une épaisseur e1 de 8nm, avec une couche en oxyde de 2nm d'épaisseur, il est nécessaire d'épitaxier 1nm de silicium pour obtenir, à la fin du procédé d'isolation, des zones oxydées présentant une épaisseur e5 de 18nm.

De plus, l'étape de croissance par épitaxie sélective est réalisée sur un film mince pas encore structuré, les motifs n'étant pas encore formés. L'étape de croissance est, ainsi, réalisée "en pleine plaque", ce qui présente l'avantage de ne pas favoriser un phénomène de démouillage prématuré, lors du procédé d'isolation. De plus, si la structure présente des contraintes internes (film contraint ou structure composite), des phénomènes de déstabilisation peuvent être observés lorsque la vitesse d'épitaxie est trop faible ou lorsque l'épaisseur des zones épitaxiées est trop élevée. Les conditions de croissance par épitaxie sélective, comme l'épaisseur des zones épitaxiées et la vitesse d'épitaxie, peuvent alors être adaptées de manière connue, pour éviter ces phénomènes de déstabilisation.

Dans une variante de réalisation, l'étape de croissance par épitaxie sélective peut être remplacée par une étape de formation sélective, au niveau des zones libres du film mince, d'une couche supplémentaire constituée par un oxyde d'un second matériau semi-conducteur. Le second matériau semi-conducteur peut être identique ou différent du matériau semi-conducteur oxydable constituant le film mince.

La formation sélective de la couche supplémentaire, au niveau des zones libres du film mince, peut être réalisée par dépôt direct sélectif de l'oxyde du second matériau semi-conducteur. Dans ce cas, l'oxydation des zones libres du film mince est réalisée à travers la couche supplémentaire d'oxyde.

La formation sélective de la couche supplémentaire, au niveau des zones libres du film mince, peut également être réalisée en déposant préalablement le second matériau semi-conducteur, puis en l'oxydant. L'oxydation du second matériau semi-conducteur peut, alors, être réalisée avant l'oxydation des zones libres du film mince qui est, alors, réalisée à travers la couche supplémentaire d'oxyde. L'oxydation du second matériau semi-conducteur peut, également, être réalisée en même temps que l'oxydation des zones libres du film mince. A titre d'exemple, il est possible de déposer sélectivement, c'est-à-dire uniquement sur les zones libres du film mince, un composé de silicium et de germanium (SiGe) sur des zones libres en silicium, du silicium sur des zones libres en SiGe, ou encore du polysilicium sur des zones libres en silicium ou en SiGe. Dans la mesure où le second matériau semi-conducteur a un paramètre de maille adapté, le dépôt sélectif du second matériau semi-conducteur sur les zones libres du film mince peut être, par exemple, réalisé par croissance par épitaxie sélective des zones libres du film mince.

Le fait de réaliser une étape de formation sélective d'une couche supplémentaire constituée par un oxyde en matériau semi-conducteur, permet, comme précédemment, d'obtenir, à la fin du procédé d'isolation, des zones oxydées ayant une épaisseur suffisante pour être conservées lors des différentes étapes de fabrication d'un micro-composant. L'épaisseur supplémentaire obtenue par la formation de la couche supplémentaire, permet, en effet, d'augmenter l'épaisseur totale des zones oxydées, à la fin du procédé d'isolation et donc d'obtenir des motifs non seulement isolés électriquement mais également stables à haute température pendant les différentes étapes de fabrication d'un micro-composant.

Dans une autre variante de réalisation, la couche en oxyde 4 du masque peut ne pas être structurée. Dans ce cas, la couche en nitrure 5 du masque 7 délimite, comme précédemment, dans le film mince 1, des zones dites recouvertes par le masque 7, c'est-à-dire à la fois par la couche en oxyde 4 et par la couche en nitrure 5 et des zones dites libres 1c, c'est-à-dire des zones uniquement recouvertes par la couche en oxyde 4. La formation sélective de la couche supplémentaire est alors effectuée sur cette couche mince en oxyde 4, uniquement au niveau des zones dites libres.

L'invention n'est pas limitée aux modes de réalisation décrits ci-dessus. Ainsi, le film mince 1 n'est pas nécessairement disposé sur un substrat SOI, c'est-à-dire sur une couche intermédiaire 2 recouvrant un support 3. Le film mince peut être disposé directement sur le support. Le support peut alors être un substrat massif, par exemple en silicium ou bien il peut être composé d'un empilement de plusieurs couches d'un ou plusieurs matériaux.

## Revendications

1. Utilisation d'un procédé d'isolation de motifs (1a) formés dans un film mince (1) en un premier matériau semi-conducteur oxydable, d'une épaisseur prédéterminée (e1) inférieure ou égale à 20nm et disposé sur un support (3), pour stabiliser thermiquement lesdits motifs à haute température et empêcher le phénomène de démouillage desdits motifs, pendant différentes étapes de fabrication d'un micro-composant, ledit procédé comportant successivement :
- la formation, sur le film mince, d'un masque (7) définissant, dans le film mince (1), des zones libres (1c) et des zones recouvertes par le masque (7),
- l'oxydation des zones libres (1c) du film mince (1),
- le retrait du masque (7) de manière à libérer le film mince (1) structuré sous forme de motifs (1 a) isolés par des zones oxydées (1 b),
utilisation **caractérisée en ce qu'**une étape de formation sélective, sur la totalité des zones libres (1c) du film mince (1), d'une couche supplémentaire constituée par un oxyde d'un second matériau semi-conducteur est réalisée entre l'étape de formation du masque et l'étape d'oxydation.

2. Utilisation selon la revendication 1, **caractérisée en ce que** l'épaisseur prédéterminée (e1) du film mince (1) est inférieure ou égale à 10 nm.

3. Utilisation selon l'une des revendications 1 et 2, **caractérisée en ce que** le second matériau semi-conducteur est identique au premier matériau semi-conducteur oxydable.

4. Utilisation selon l'une des revendications 1 et 2, **caractérisée en ce que** le second matériau semi-conducteur est différent du premier matériau semi-conducteur.

5. Utilisation selon l'une quelconque des revendications 1 à 4, **caractérisée en ce que** la formation sélective de la couche supplémentaire est réalisée par un dépôt sélectif direct de l'oxyde du second matériau semi-conducteur.

6. Utilisation selon l'une quelconque des revendications 1 à 4, **caractérisée en ce que** la formation sélective de la couche supplémentaire est réalisée par un dépôt sélectif du second matériau semi-conducteur suivi par son oxydation.

7. Utilisation selon la revendication 6, **caractérisée en ce que** le dépôt sélectif du second matériau semi-conducteur est réalisé par croissance par épitaxie sélective des zones libres (1c) du film mince (1).

8. Utilisation selon l'une des revendications 6 et 7, **caractérisée en ce que** l'oxydation du second matériau semi-conducteur est réalisée en même temps que l'étape d'oxydation des zones libres (1c) du film mince (1).

9. Utilisation selon l'une des revendications 6 et 7, **caractérisée en ce que** l'oxydation du second matériau semi-conducteur est réalisée, avant l'étape d'oxydation des zones libres (1c) du film mince (1).

10. Utilisation dé selon l'une quelconque des revendications 1 à 9, **caractérisée en ce que** l'épaisseur de la couche supplémentaire est déterminée de manière à ce que les motifs (1a) restent isolés par des zones oxydées (1b) pendant toute la durée d'un procédé de fabrication de micro-composants.

11. Utilisation selon l'une quelconque des revendications 1 à 10, **caractérisée en ce que** la formation du masque (7) sur le film mince (1) comporte le dépôt successif, sur la totalité du film mince (1), de deux couches, respectivement en oxyde (4) et en nitrure (5) et au moins la structuration sélective de la couche en nitrure (5) pour former ledit masque (7).

12. Utilisation selon la revendication 11, **caractérisée en ce que** les couches, respectivement en nitrure (5) et en oxyde (4), sont structurées successivement.

13. Utilisation selon l'une des revendications 1 à 12, **caractérisée en ce qu**'une couche Intermédiaire (2) est disposée entre le film mince (1) et le support (3).

14. Utilisation selon la revendication 13, **caractérisée en ce que** la couche intermédiaire (2) est une couche isolante électriquement constituée par un composé choisi parmi la silice amorphe, l'alumine, le nitrure de silicium, le quartz et l'oxyde d'hafnium.

15. Utilisation selon la revendication 13, **caractérisée en ce que** la couche intermédiaire (2) est constituée par un composé de silicium et de germanium.

16. Utilisation selon l'une quelconque des revendications 1 à 15, **caractérisée en ce que** les premier et second matériaux semi-conducteurs sont choisis parmi le silicium et un composé de silicium et de germanium.

17. Utilisation selon l'une quelconque des revendications 1 à 16, **caractérisée en ce que** le support (3) est formé par un matériau différent du premier matériau semi-conducteur oxydable.

## Claims

1. Use of a method for insulating patterns (1 a) formed in a thin film (1) made of a first oxidizable semi-conducting material, with a predetermined thickness (e1) less than or equal to 20nm and arranged on a support (3), for thermally stabilizing said patterns at high temperature and preventing the dewetting phenomenon of said patterns, during different fabrication steps of a micro-component, said process successively comprising:
- formation, on the thin film, of a mask (7) delimiting, in the thin film (1), free zones (1c) and zones covered by the mask (7),
- oxidization of the free zones (1 c) of the thin film (1),
- removal of the mask (7) so as to release the thin film (1) patterned in the form of patterns (1 a) that are insulated by oxidized zones (1 b),
use **characterized in that** a selective formation step of an additional layer made of an oxide of a second semi-conducting material is performed on the whole of the free zones (1c) of the thin film (1), between the mask formation step and the oxidizing step.

2. Use according to claim 1, **characterized in that** at the predetermined thickness (e1) of the thin film (1) is less than or equal to 10 nm.

3. Use according to one of the claims 1 and 2, **characterized in that** the second semi-conducting material is identical to the first oxidizable semi-conducting material.

4. Use according to one of the claims 1 and 2, **characterized in that** the second semi-conducting material is different from the first semi-conducting material.

5. Use according to any one of the claims 1 to 4, **characterized in that** selective formation of the additional layer is performed by direct selective deposition of the oxide of the second semi-conducting material.

6. Use according to any one of the claims 1 to 4, **characterized in that** selective formation of the additional layer is performed by selective deposition of the second semi-conducting material followed by oxidizing thereof.

7. Use according to claim 6, **characterized in that** selective deposition of the second semi-conducting material is performed by selective epitaxial growth of the free zones (1c) of the thin film (1).

8. Use according to one of the claims 6 and 7, **characterized in that** oxidizing of the second semi-conducting material is performed at the same time as the oxidizing step of the free zones (1c) of the thin film (1).

9. Use according to one of the claims 6 and 7, **characterized in that** oxidizing of the second semi-conducting material is performed before the oxidizing step of the free zones (1 c) of the thin film (1).

10. Use according to any one of the claims 1 to 9, **characterized in that** the thickness of the additional layer is determined in such a way that the patterns (1a) remain insulated by oxidized zones (1b) throughout the duration of a micro-components fabrication method.

11. Use according to any one of the claims 1 to 10, **characterized in that** formation of the mask (7) on the thin film (1) comprises successive deposition, over the whole of the thin film (1), of two layers, respectively an oxide layer (4) and a nitride layer (5), and at least selective patterning of the nitride layer (5) to form said mask (7).

12. Use according to claim 11, **characterized in that** the layers, respectively the nitride layer (5) and oxide layer (4), are patterned successively.

13. Use according to one of the claims 1 to 12, **characterized in that** an intermediate layer (2) is arranged between the thin film (1) and the support (3).

14. Use according to claim 13, **characterized in that** the intermediate layer (2) is an electrically insulating layer formed by a compound chosen from among amorphous silica, alumina, silicon nitride, quartz and hafnium oxide.

15. Use according to claim 13, **characterized in that** the intermediate layer (2) is formed by a silicon and germanium compound.

16. Use according to any one of the claims 1 to 15, **characterized in that** the first and second semi-conducting materials are chosen from among silicon and a silicon and germanium compound.

17. Use according to any one of the claims 1 to 16, **characterized in that** the support (3) is formed by a material different from the first oxidizable semi-conducting material.

## Patentansprüche

1. Anwendung eines Verfahrens zur Isolierung von Motiven (1a), die in einer dünnen Schicht (1) aus einem ersten oxidierbaren Halbleitermaterial gebildet sind, die eine vorbestimmte Dicke (e1) von unter oder gleich 20 nm aufweist und auf einem Träger (3) angeordnet ist, zur Wärmestabilisierung der Motive bei hoher Temperatur und Vermeidung des Entnetzungsphänomens dieser Motive während unterschiedlicher Phasen der Herstellung einer Mikrokomponente, welches Verfahren nacheinander umfasst:
- die Herstellung einer Maske (7) auf der dünnen Schicht (1), die in der dünnen Schicht (1) von der Maske (7) unbedeckte Bereiche (1 c) und bedeckte Bereiche definiert,
- Oxidierung der unbedeckten Bereiche (1 c) der dünnen Schicht (1),
- Entfernung der Maske (7) zur Freilegung der dünnen Schicht (1), die in Form von Motiven (1a) strukturiert ist, die durch oxidierte Bereiche (1 b) voneinander isoliert sind,
Anwendung, die **dadurch gekennzeichnet ist, dass** zwischen dem Maskenherstellungsschritt und dem Oxidierungsschritt ein Schritt der selektiven Bildung einer zusätzlichen Schicht in allen unbedeckten Bereichen (1c) der dünnen Schicht (1) stattfindet, die aus einem Oxid eines zweiten Halbleitermaterials besteht.

2. Anwendung nach Anspruch 1, **dadurch gekennzeichnet, dass** die vorbestimmte Dicke (e1) der dünnen Schicht (1) weniger als oder gleich 10 nm beträgt.

3. Anwendung nach einem der Ansprüche 1 und 2, **dadurch gekennzeichnet, dass** das zweite Halbleitermaterial identisch ist mit dem ersten oxidierbaren Halbleitermaterial.

4. Anwendung nach einem der Ansprüche 1 und 2, **dadurch gekennzeichnet, dass** das zweite Halbleitermaterial ein anderes ist als das erste Halbleitermaterial.

5. Anwendung nach einem der Ansprüche 1 bis 4, **dadurch gekennzeichnet, dass** die selektive Bildung der zusätzlichen Schicht durch ein direktes selektives Aufbringen des Oxids des zweiten Halbleitermaterials erfolgt.

6. Anwendung nach einem der Ansprüche 1 bis 4, **dadurch gekennzeichnet, dass** die selektive Bildung der zusätzlichen Schicht durch ein selektives Aufbringen des zweiten Halbleitermaterials erfolgt, gefolgt von dessen Oxidierung.

7. Anwendung nach Anspruch 6, **dadurch gekennzeichnet, dass** das selektive Aufbringen des zweiten Halbleitermaterials durch selektives Epitaxiewachstum der unbedeckten Bereiche (1 c) der dünnen Schicht (1) erfolgt.

8. Anwendung nach einem der Ansprüche 6 und 7, **dadurch gekennzeichnet, dass** die Oxidierung des zweiten Halbleitermaterials zur gleichen Zeit erfolgt wie der Schritt der Oxidierung der unbedeckten Bereiche (1 c) der dünnen Schicht (1).

9. Anwendung nach einem der Ansprüche 6 und 7, **dadurch gekennzeichnet, dass** die Oxidierung des zweiten Halbleitermaterials vor dem Oxidierungsschritt der unbedeckten Bereiche (1 c) der dünnen Schicht (1) erfolgt.

10. Anwendung nach einem der Ansprüche 1 bis 9, **dadurch gekennzeichnet, dass** die Dicke der zusätzlichen Schicht so bestimmt ist, dass die Motive (1a) während der ganzen Dauer eines Verfahrens zur Herstellung Mikromkomponente durch oxidierte Bereiche (1 b) voneinander isoliert bleiben.

11. Anwendung nach einem der Ansprüche 1 bis 10, **dadurch gekennzeichnet, dass** die Herstellung der Maske (7) auf der dünnen Schicht (1) das aufeinanderfolgende Aufbringen zweier Schichten aus jeweils Oxid (4) bzw. Nitrid (5) auf die gesamte dünne Schicht (1) und zumindest die selektive Strukturierung der Nitridschicht (5) zur Herstellung der Maske (7) umfasst.

12. Anwendung nach Anspruch 11, **dadurch gekennzeichnet, dass** die Schichten aus Nitrid (5) bzw. Oxid (4) nacheinander strukturiert werden.

13. Anwendung nach einem der Ansprüche 1 bis 12, **dadurch gekennzeichnet, dass** eine Zwischenschicht (2) zwischen der dünnen Schicht (1) und dem Träger (3) angeordnet ist.

14. Anwendung nach Anspruch 13, **dadurch gekennzeichnet, dass** die Zwischenschicht (2) eine elektrisch isolierende Schicht ist, die von einer Verbindung gebildet wird, die aus amorphem Silizium, Aluminiumoxid, Siliziumnitrid, Quarz und Hafniumoxid ausgewählt ist.

15. Anwendung nach Anspruch 13, **dadurch gekennzeichnet, dass** die Zwischenschicht (2) von einer Silizium-Germaniumverbindung gebildet wird.

16. Anwendung nach einem der Ansprüche 1 bis 15, **dadurch gekennzeichnet, dass** das erste und das zweite Halbleitermaterial aus Silizium und einer Silizium-Germaniumverbindung ausgewählt ist.

17. Anwendung nach einem der Ansprüche 1 bis 16, **dadurch gekennzeichnet, dass** der Träger (3) von einem anderen Material als dem ersten oxidierbaren Halbleitermaterial gebildet wird.
